# EUROPÄISCHE PATENTANMELDUNG

(11) **EP 1 328 142 A2**
(43) Veröffentlichungstag der Anmeldung: **16.07.2003**
(21) Anmeldenummer: 02028224.0
(22) Anmeldetag: 01.01.2003
(51) Int. Cl.: H05K 3/20, H05K 7/14

(54) **Schaltungsanordnung**

(30) Priorität: 15.01.2002 DE 10201165
(71) Anmelder: ROBERT BOSCH GMBH, 70442 Stuttgart (DE)
(72) Erfinder: Uhland, Thomas, 74397 Pfaffenhofen-Weiler (DE); Beckbissinger, Kai, 70569 Stuttgart (DE); Mueller-Hirsch, Wolfgang, 73730 Esslingen (DE); Schinzel, Ralf, 71672 Marbach Am Neckar (DE); Hennel, Udo, 03150 Victoria Glen Waverley (DE)

(57) **Zusammenfassung**

Es wird eine Schaltungsanordnung vorgeschlagen, die sich zum einen sehr kompakt realisieren lässt und zum anderen Schwingungsbelastungen sehr gut standhält.
Die Schaltungsanordnung ist zumindest teilweise auf einer ersten Leiterplatte (4) realisiert und umfasst mindestens ein bedrahtetes Bauelement (14, 15). Das bedrahtete Bauelement (14, 15) ist erfindungsgemäß auf einem eigenen Bauelementeträger (5) angeordnet. Außerdem sind die erste Leiterplatte (4) und der Bauelementeträger (5) übereinander angeordnet und mechanisch miteinander verbunden.

## Beschreibung

### Stand der Technik

Die Erfindung betrifft eine Schaltungsanordnung, die zumindest teilweise auf einer ersten Leiterplatte realisiert ist und mindestens ein bedrahtetes Bauelement umfasst.

Die nachfolgend genannten Anforderungen an eine derartige Schaltungsanordnung für ein Motorsteuergerät werden zumindest teilweise auch an Schaltungsanordnungen für andere Anwendungen gestellt. Im Zuge des allgemeinen Trends hin zu einer kompakten Bauweise sollen auch die Abmaße von Motorsteuergeräten immer kleiner werden, um einen Einbau in den immer enger werdenden Motorraum zu ermöglichen. Außerdem müssen Motorsteuergeräte immer höheren Temperatur- und Schwingungsbelastungen standhalten

### Vorteile der Erfindung

Mit der vorliegenden Erfindung wird eine Schaltungsanordnung vorgeschlagen, die sich zum einen sehr kompakt realisieren lässt und zum anderen Schwingungsbelastungen sehr gut standhält.

Dies wird erfindungsgemäß dadurch erreicht, dass das bedrahtete Bauelement bzw. mehrere bedrahtete Bauelemente auf einem eigenen Bauelementeträger angeordnet ist bzw. sind und dass die erste Leiterplatte und der Bauelementeträger übereinander angeordnet und mechanisch miteinander verbunden sind.

Es ist erkannt worden, dass insbesondere die Montage und die elektrische Kontaktierung von großen bedrahteten Bauelementen, wie z.B. Kondensatoren und Spulen, problematisch ist, wenn die Schaltungsanordnung Erschütterungen und Schwingungsbelastungen ausgesetzt ist. Erfindungsgemäß wird deshalb vorgeschlagen, diese Bauelemente auf einem eigenen Bauelementeträger zu montieren. Bei geeigneter Ausgestaltung des Bauelementeträgers und entsprechender Wahl der Montagetechnik kann die Schüttelfestigkeit der Bauelementeanordnung so wesentlich erhöht werden. Außerdem können Sonderbauelemente einfach unabhängig von anderen Teilen der Schaltungsanordnung auf dem Bauelementeträger montiert und beispielsweise vorab geprüft werden, so dass der Bauelementeträger als Montageeinheit wie ein einzelnes Bauelement in der Schaltungsanordnung verbaut werden kann. Erfindungsgemäß sind die Leiterplatte und der Bauelementeträger übereinander angeordnet, so dass sich die erfindungsgemäße Schaltungsanordnung sehr kompakt realisieren lässt. Die großen bedrahteten Bauelemente sind also nicht nur auf einem eigenen Bauelementeträger sondern auch auf einer eigenen Ebene angeordnet, so dass die erfindungsgemäße Schaltungsanordnung in mindestens zwei Ebenen aufgebaut ist. Schließlich sind die Leiterplatte und der Bauelementeträger erfindungsgemäß auch mechanisch miteinander verbunden. Dadurch wird eine Versteifung der gesamten Schaltungsanordnung, d.h. nicht nur des Bauelementeträgers sondern auch der Leiterplatte, erreicht, so dass bei Schwingungsbeanspruchungen auch die Bauelemente auf der Leiterplatte, wie z.B. µ-Prozessoren, weniger belastet werden. Die Kombination aller erfindungsgemäßen Maßnahmen resultiert in einer hohen Schüttelfestigkeit der gesamten Schaltungsanordnung.

Grundsätzlich gibt es unterschiedliche Möglichkeiten für die Realisierung einer erfindungsgemäßen Schaltungsanordnung.

Ein Aspekt betrifft die elektrische Kontaktierung der Bauelemente auf dem Bauelementeträger. Die elektrische Verbindung zwischen diesen Bauelementen und dem auf der Leiterplatte realisierten Schaltungsteil kann beispielsweise über Drähte oder eine Steckeranordnung erfolgen. In einer besonders vorteilhaften Variante, die ohne zusätzliche Schwachstellen im Hinblick auf eine mechanische Beanspruchung der Schaltungsanordnung auskommt, wird die elektrische Verbindung zwischen den Bauelementen auf dem Bauelementeträger und dem auf der Leiterplatte realisierten Schaltungsteil über den Bauelementeträger selbst hergestellt, der ja erfindungsgemäß ohnehin mechanisch mit der Leiterplatte verbunden ist.

Wie bereits erwähnt, gibt es auch unterschiedliche Möglichkeiten für die Realisierung des Bauelementeträgers. So kann beispielsweise eine zweite Leiterplatte als Bauelementeträger dienen. In diesem Fall können die Bauelemente einfach über die zweite Leiterplatte, also den Bauelementeträger, elektrisch kontaktiert werden.

In einer besonders vorteilhaften Variante der Erfindung dient ein aus einem Metallblech gefertigtes Stanzgitter als Bauelementeträger. Bei entsprechendem Layout des Stanzgitters können auch in diesem Fall die Bauelemente über den Bauelementeträger elektrisch kontaktiert werden. Außerdem lassen sich Bauelementeträger in Form von Stanzgittern einfach und sehr präzise in großen Stückzahlen fertigen, was sich günstig auf die Herstellungskosten auswirkt. In einer vorteilhaften Weiterbildung der erfindungsgemäßen Schaltungsanordnung ist das Stanzgitter kunststoffumspritzt, was die Positionierung und Fixierung des Bauelementeträgers vereinfacht. In einer solchen Kunststoffumspritzung können außerdem Aufnahmen für die Bauelemente ausgebildet sein, die eine präzise Montage der Bauelemente auf dem Bauelementeträger vereinfachen. Die Aufnahmen können so an die individuelle Form der einzelnen Bauelemente angepasst sein, dass sie zur Fixierung der Bauelemente und damit zur Schüttelfestigkeit der gesamten Schaltungsanordnung beitragen. Zur Montage können die Bauelemente dann beispielsweise einfach in den entsprechenden Aufnahmen des kunststoffumspritzten Stanzgitters verklebt werden. Des Weiteren können in der Kunststoffumspritzung des Bauelementeträgers Versteifungsrippen ausgebildet sein, die ebenfalls zur Versteifung der gesamten Schaltungsanordnung und damit zur Erhöhung der Schüttelfestigkeit beitragen.

### Zeichnungen

Wie bereits voranstehend ausführlich erörtert, gibt es unterschiedliche Möglichkeiten, die Lehre der vorliegenden Erfindung in vorteilhafter Weise auszugestalten und weiterzubilden. Dazu wird einerseits auf die dem Patentanspruch 1 nachgeordneten Patentansprüche und andererseits auf die nachfolgende Beschreibung eines Ausführungsbeispiels der Erfindung anhand der Zeichnungen verwiesen.
- Fig. 1: zeigt eine Explosionsdarstellung eines Motorsteuergeräts mit einer erfindungsgemäßen Schaltungsanordnung,
- Fig. 2: zeigt ein Stanzgitter, das als Basis für den Bauelementeträger der in Fig. 1 dargestellten Schaltungsanordnung dient,
- Fig. 3: zeigt das in Fig. 2 dargestellte Stanzgitter mit einer Kunststoffumspritzung und
- Fig. 4: zeigt den in Fig. 3 dargestellten Bauelementeträger nach der Montage der Bauelemente.

### Beschreibung des Ausführungsbeispiels

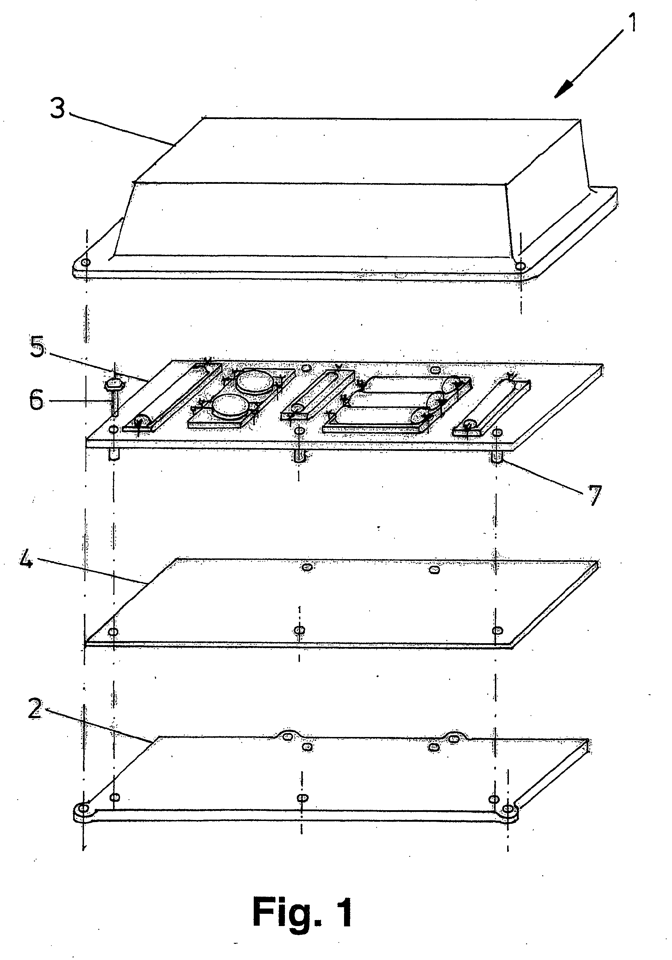

Das in Fig. 1 dargestellte Motorsteuergerät 1 umfasst eine erfindungsgemäße Schaltungsanordnung, die in einem Gehäuse angeordnet ist. Das Gehäuse besteht aus einer Grundplatte 2 und einem Deckel 3. Die Grundplatte 2 ist hier aus AI-Guß gefertigt und der Deckel 3 aus Stahlblech.

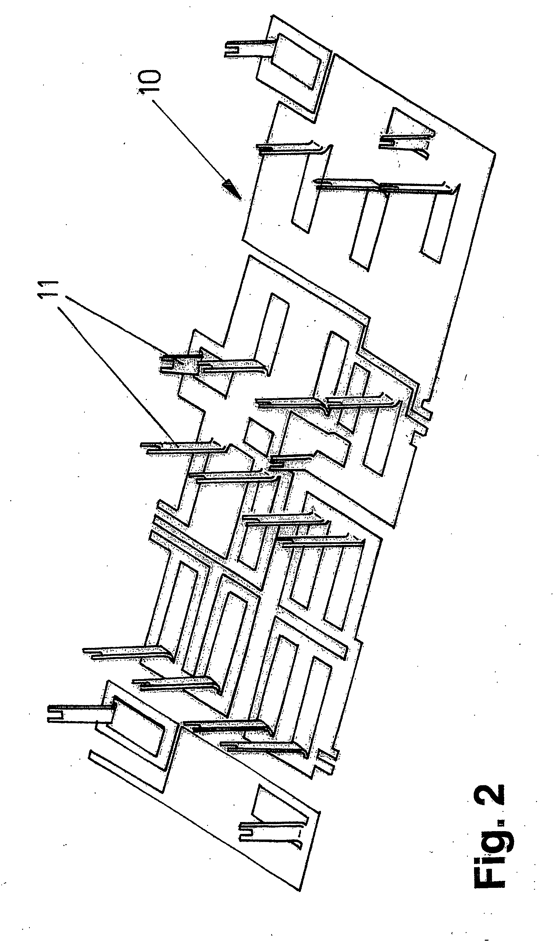

Ein Teil der Schaltungsanordnung ist auf einer Leiterplatte 4 realisiert. Daneben umfasst die Schaltungsanordnung noch mehrere schüttelkritische, bedrahtete Bauelemente, wie Elektrolyth-Kondensatoren und Drosselspulen. Diese sind auf einem separaten Bauelementeträger 5 angeordnet, d.h. mechanisch fixiert und elektrisch kontaktiert. Der Bauelementeträger 5 wird nachfolgend in Verbindung mit den Figuren 2 bis 4 näher erläutert. Die Explosionsdarstellung der Fig. 1 verdeutlicht, dass die Leiterplatte 4 und der Bauelementeträger 5 übereinander angeordnet und mechanisch miteinander verbunden sind. Dazu dienen im hier dargestellten Ausführungsbeispiel Verbindungsschrauben 6, die durch Anschraubdome 7 am Bauelementeträger 5 und der Leiterplatte 4 geführt sind. Mit Hilfe dieser Verbindungsschrauben 6 werden der Bauelementeträger 5 und die Leiterplatte 4 außerdem mit der Grundplatte 2 des Gehäuses verschraubt. Dadurch werden sowohl der Bauelementeträger 5 als auch die Leiterplatte 4 zusätzlich versteift.

Die elektrische Verbindung zwischen den Bauelementen auf dem Bauelementeträger 5 und dem Schaltungsteil auf der Leiterplatte 4 wird im hier dargestellten Ausführungsbeispiel über den Bauelementeträger 5 selbst hergestellt, der hier in Form eines kunststoffumspritzten Metallblech-Stanzgitters 10 realisiert ist.

In Fig. 2 ist das Stanzgitter 10 dargestellt, bevor es mit einer Kunststoffumspritzung versehen worden ist. Das Layout des Stanzgitters 10 ist an die Anzahl und Größe der Bauelemente angepasst, die auf dem Bauelementeträger 5 angeordnet werden sollen. Insbesondere umfasst das Layout Anschlussstifte 11, die aus der Gitterebene des Stanzgitters 10 herausgebogen worden sind, so dass sie senkrecht von der Gitterebene abragen. Die Anzahl und die Abstände zwischen den einzelnen Anschlussstifte 11 sind entsprechend der Anzahl und den Abmessungen der Bauelemente gewählt.

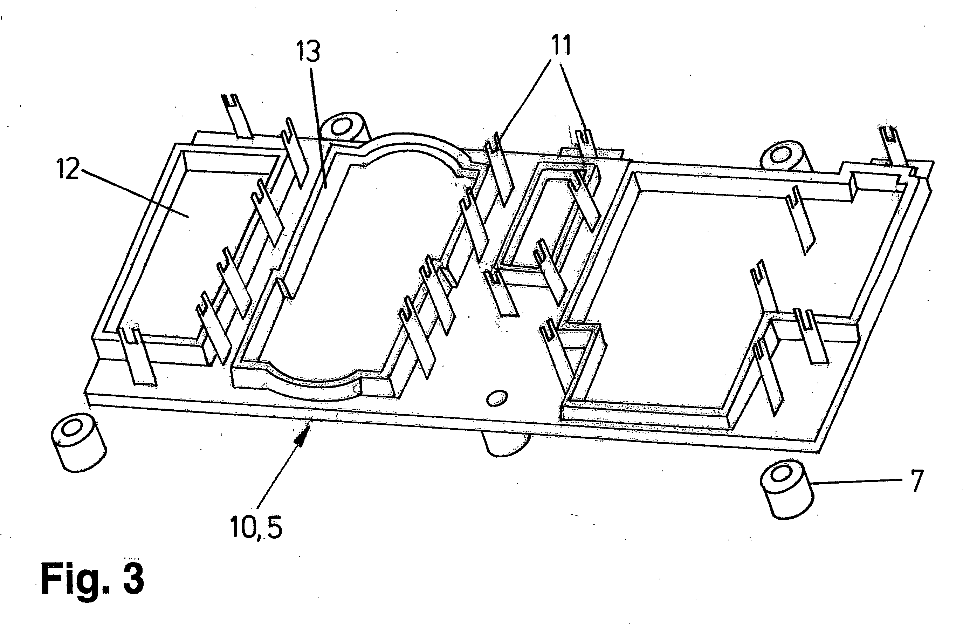

Fig. 3 zeigt das in Fig. 2 dargestellte Stanzgitter 10, nachdem es mit einer Kunststoffumspritzung versehen worden ist. Die Kunststoffumspritzung des Stanzgitters 10 vereinfacht die Positionierung des Bauelementeträgers 5 bezüglich der Leiterplatte 4 und die Fixierung im Gehäuse. In der Kunststoffumspritzung sind Wannen 12 ausgebildet, die als Aufnahmen für die einzelnen Bauelemente dienen und dementsprechend dimensioniert sind. Außerdem sind in der Kunststoffumspritzung Versteifungsrippen 13 ausgebildet, die zum einen den Bauelementeträger 5 in sich versteifen, zum anderen aber auch die mit dem Bauelementeträger 5 verbundene Leiterplatte 4. Wie bereits erwähnt, werden der Bauelementeträger 5 und die Leiterplatte 4 über die Anschraubdome 7 gegen die Grundplatte 2 des Gehäuses geschraubt. Dadurch kann die frei schwingende Fläche der Leiterplatte 4 erheblich reduziert werden. An dieser Stelle sei angemerkt, dass die mechanische Verbindung zwischen der Leiterplatte 4 und dem Bauelementeträger 5 auch in anderer Weise hergestellt werden kann, wie z.B. durch Löten oder Verschweißen.

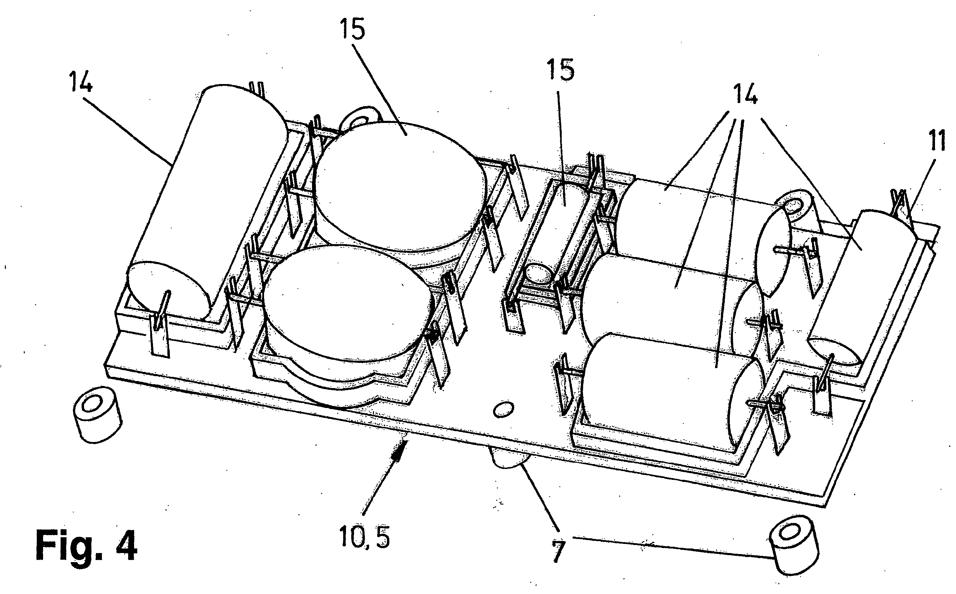

Fig. 4 zeigt die Anordnung von einzelnen Elektrolyth-Kondensatoren 14 und Drosselspulen 15 auf dem Bauelementeträger 5. Die einzelnen Bauelemente 14 und 15 sind in die jeweils dafür vorgesehenen Wannen 12 der Kunststoffumspritzung geklebt. Dadurch sind die Bauelemente 14 und 15 besonders gut auf dem Bauelementeträger 5 fixiert, so dass die Verbindungsstellen zwischen den Anschlussstiften 11 und den Bauelementen 14 und 15 weitgehend entlastet sind.

## Patentansprüche

1. Schaltungsanordnung, die zumindest teilweise auf einer ersten Leiterplatte (4) realisiert ist und mindestens ein bedrahtetes Bauelement (14, 15) umfasst,
**dadurch gekennzeichnet, dass** das bedrahtete Bauelement (14, 15) auf einem Bauelementeträger (5) angeordnet ist und dass die erste Leiterplatte (4) und der Bauelementeträger (5) übereinander angeordnet und mechanisch miteinander verbunden sind.

2. Schaltungsanordnung nach Anspruch 1, **dadurch gekennzeichnet, dass** die elektrische Verbindung zwischen dem Bauelement (14, 15) und dem auf der ersten Leiterplatte (4) realisierten Schaltungsteil über den Bauelementeträger (5) hergestellt ist.

3. Schaltungsanordnung nach einem der Ansprüche 1 oder 2, **dadurch gekennzeichnet, dass** eine zweite Leiterplatte als Bauelementeträger dient.

4. Schaltungsanordnung nach einem der Ansprüche 1 oder 2, **dadurch gekennzeichnet, dass** ein aus einem Metallblech gefertigtes Stanzgitter (10) als Bauelementeträger (5) dient.

5. Schaltungsanordnung nach Anspruch 4, **dadurch gekennzeichnet, dass** das Stanzgitter (10) kunststoffumspritzt ist und dass die Kunststoffumspritzung an die Form des Bauelements (14, 15) angepasst ist.

6. Schaltungsanordnung nach Anspruch 5, **dadurch gekennzeichnet, dass** das Bauelement (14, 15) in einer entsprechenden Aufnahme (12) im Bauelementeträger (5) verklebt ist.

7. Schaltungsanordnung nach einem der Ansprüche 5 oder 6, **dadurch gekennzeichnet, dass** die Kunststoffumspritzung des Bauelementeträgers (5) Versteifungsrippen (13) umfasst.

8. Motorsteuergerät (1) mit einer Schaltungsanordnung nach einem der Ansprüche 1 bis 7 und mit einem Gehäuse für die Schaltungsanordnung, **dadurch gekennzeichnet, dass** schüttelkritische Bauelemente (14, 15) auf dem Bauelementeträger (5) angeordnet sind, insbesondere Elektrolyth-Kondensatoren (14) und Spulen (15), und dass die Montageeinheit bestehend aus der ersten Leiterplatte (4) und dem Bauelementeträger (5) mit dem Gehäuse verbunden ist.
